# EUROPEAN PATENT APPLICATION

(11) **EP 4 685 816 A2**
(43) Date of publication of application: **28.01.2026**
(21) Application number: 25190773.9
(22) Date of filing: 21.07.2025
(51) Int. Cl.: G21H 1/06

(54) **STACK-TYPE ISOTOPE BATTERY**

(30) Priority: 22.07.2024 KR 20240096587; 18.07.2025 KR 20250097316
(71) Applicant: LG Energy Solution, Ltd., Seoul 07335 (KR)
(72) Inventor: KIM, Dong Myung, 34122 Daejeon (KR); KIM, Je Young, 34122 Daejeon (KR); SHIN, Dong Myung, 34122 Daejeon (KR); CHO, Young Min, 34122 Daejeon (KR)
(74) Representative: BCKIP Part mbB

(57) **Abstract**

A isotope battery includes: a plurality of isotope cell sheets that are stacked, where each of the plurality of isotope cell sheets includes: a semiconductor substrate; and a radiation source arranged in a cavity of the semiconductor substrate. The semiconductor substrate comprises a first region having a specific conductive type disposed at a side of the radiation source and a second region having a conductive type different from that of the first region. The first and the second regions are disposed adjacent in a width direction of the respective sheet, so that they form a p-n-junction extending vertically, and the radiation source is disposed spaced from the p-n-junction. The isotope battery of the present invention has the effect of generating electrical energy with a high energy density.

## Description

### [Technical Field]

The present invention relates to an isotope battery.

### [Background Technology of the Invention]

An isotope battery is a battery that absorbs radiation emitted by radioactive isotopes, through the surface of a p-n junction semiconductor and converts them into electrical energy. The radiation generates electron-hole pairs in the space charge region of the p-n junction semiconductor, and the generated carriers have the voltage-current characteristics of an isotope battery.

### [Summary of the Invention]

It is an object of the present invention to provide an isotope battery capable of generating electrical energy with high energy density.

To accomplish the above technical problem, the present invention provides an isotope battery in accordance with independent claim 1 and an isotope battery in accordance with claim 15. Moreover, the present invention also provides a non-volatile memory device in accordance with independent claim 25. Further preferred features are defined in dependent claims.

According to an embodiment, an isotope battery may include a plurality of isotope battery sheets that are stacked, each of the plurality of isotope battery sheets including: a semiconductor substrate; and a radiation source embedded in the semiconductor substrate, wherein the semiconductor substrate includes a first region having a first conductive type disposed on a side of the radiation source and a second region having a second conductive type disposed on a side of the first region.

According to the present invention, an isotope battery comprises a plurality of isotope cell sheets. Each of the cell sheets may include: a) a semiconductor substrate having a top major surface and a bottom major surface positioned opposite to the top major surface in a substrate thickness direction, wherein the semiconductor substrate includes: a-1) a first region and a second region of different conductive types, forming a p-n-junction, wherein the first region and the second region are arranged adjacent to each other along an extension direction of the top and bottom major surfaces; and a-2) a cavity extending from the top major surface in the substrate thickness direction, at a position spaced apart from the p-n-junction; and b) a radiation source arranged in the cavity. The plurality of cell sheets may be stacked on top of each other in a direction parallel to the substrate thickness direction. The isotope battery may comprise a first external electrode of a first polarity and a second external electrode of a second polarity respectively connected to the plurality of isotope cell sheets to provide an electrical connection to an external load.

Further, the semiconductor substrate may include a plurality of cavities. Preferably, a respective radiation source may be provided inside each of the plurality of cavities.

Optionally, the cavity may extend till the bottom major surface.

The cavity may be a through-hole having a cross-sectional shape of, for example, a circle or a regular polygon or substantially a regular polygon.

The plurality of cavities may be disposed in the semiconductor substrate such that their respective centers are located at vertices of an imaginary triangle, preferably an imaginary equilateral or isosceles triangle.

The cavity may have, on the top major surface, a longitudinal extension substantially greater than a width thereof.

Optionally, the first region may surround the radiation source at least partially. Additionally or alternatively, the second region may surround the first region at least partially.

Moreover, the first region may extend along the longitudinal extension of the cavity, facing a longitudinal side of the radiation source. Additionally or alternatively, the second region may extend along the longitudinal extension of the cavity, facing a longitudinal side of the first region.

Preferably, the cavity may include a stepped recess having a first recess at the top major surface of the semiconductor substrate, and a through hole running from a bottom of the first recess toward the bottom major surface of the semiconductor substrate. More preferably, the radiation source may comprise a first portion disposed in the first recess, and a second portion in the through hole.

Desirably, the plurality of isotope cell sheets of the present invention may be identically configured.

Besides, center lines running through the radiation sources of the stacked cell sheets may be aligned to form a straight line.

Preferably, at least a part of the p-n-junction of a respective cell sheet may be aligned with at least a part of the p-n-junction of another cell sheet disposed directly on top or underneath, so that the p-n junctions substantially overlap each other.

Furthermore, the plurality of isotope cell sheets may be electrically connected to each other by connectors.

Optionally, the first regions of cell sheets disposed directly on top and underneath may be electrically connected to each other. Additionally or alternatively, the second regions of cell sheets disposed directly on top and underneath may be electrically connected to each other.

According to another aspect of the present invention, an isotope battery comprises a plurality of semiconductor substrates. Each semiconductor substrate may include: a) a top major surface and a bottom major surface positioned opposite to the top major surface in a substrate thickness direction; b) a first region of a first conductive type and a second region of a second conductive type, forming a p-n-junction at an interface (IF) therebetween, wherein the first region and the second region are arranged adjacent to each other along an extension direction of the top and bottom major surfaces; and c) a plurality of cavities in each of the first and second regions. The semiconductor substrates may be stacked on top of each other in a direction parallel to the substrate thickness direction, forming a stack. Further, the interfaces (IF) of the stacked semiconductor substrates disposed directly on top and underneath may be aligned, so that the interfaces (IF) overlap each other, forming a first zone (Z1) and a second zone (Z2) at opposite sides of the aligned interfaces (IF). Furthermore, respectively in the first zone (Z 1) and the second zone (Z2), the first and the second region may be alternately stacked. Moreover, the isotope battery may comprise a plurality of radiation sources disposed in the plurality of cavities.

Optionally, the cavities may be arranged such that the radiation sources in the first zone (Z 1) and the radiation sources in the second zone (Z2) are symmetrically arranged with respect to the interface (IF).

Preferably, the isotope battery according to the present invention may further comprise a controller chip provided on one side of the plurality of isotope cell sheets. Herein, the controller chip may be configured to control output of electrical energy generated.

Desirably, the plurality of cell sheets or the plurality of semiconductor substrates may be embedded in a molding resin.

Moreover, at least one dummy electrode may be exposed through the molding resin.

The radiation source may extend longitudinally and has a central opening extending in the longitudinal direction.

Possibly, the radiation source may be cylindrically shaped.

The central opening may be filled, preferably with an insulating material (162) or a semiconductor material.

The isotope battery according to the present invention may further comprise a photon generating layer disposed to at least partially surround the radiation source, so that radiation emitted by the radiation source is incident on the photon generating layer. The photon generating layer may be configured to emit photons in response to being irradiated by the radiation source towards the p-n-junction of a respective isotope cell sheet or a respective semiconductor substrate.

Preferably, the photon generating layer may be disposed between the p-n-junction and the radiation source.

According to a different aspect of the present invention, a non-volatile memory device comprises: at least one semiconductor memory device; a memory control device configured to control operation of the at least one semiconductor memory device; and an isotope battery configured to power the memory control device.

The semiconductor memory device may be a DRAM chip.

According to the present invention, multiple cell sheets may be stacked on top of each other in a vertical direction. Each cell sheet may comprise a semiconductor substrate in which a p-n-junction is formed. At least one radiation source may be integrated into each cell sheet. The p-n-junctions, preferably, extend in the vertical direction.

The isotope battery of the present invention has the effect of generating electric energy with a high energy density.

The effects that may be obtained from the exemplary examples of the present invention are not limited to those mentioned above, and other effects not mentioned may be clearly derived and understood by one of ordinary skill in the art to which the exemplary examples of the present invention belong from the following description. That is, unintended effects of practicing the exemplary examples of the present invention may also be derived from the exemplary examples of the present invention by one of ordinary skill in the art.

### [Brief Description of the Drawings]

FIGS. 1a and 1b are side cross-sectional views illustrating an isotope battery according to embodiments of the present invention.
FIG. 2a is a plan view of a cell sheet of an isotope battery according to an embodiment of the invention.
FIG. 2b is a plan view of a cell sheet of an isotope battery according to a further embodiment of the invention.
FIG. 2c is a plan view of a cell sheet of an isotope battery according to a further embodiment of the invention.
FIG. 3a is a plan view of a cell sheet of an isotope battery according to a still further embodiment of the invention.
FIG. 3b is a plan view of a cell sheet of an isotope battery according to a further embodiment of the invention.
FIG. 4 is a cross-sectional view of a isotope battery according to a further embodiment of the invention.
FIG. 5 is a cross-sectional view of a isotope battery according to a further embodiment of the invention.
FIG. 6a is a cross-sectional view of a isotope batter according to a further embodiment of the invention.
FIG. 6b is a plan view of a cell sheet of the isotope battery of FIG. 6a.
FIG. 6c is a cross-sectional view along line X-X of FIG. 6b.
FIG. 7 is side cross-sectional views of a isotope battery according to a further embodiment of the present invention.
FIG. 8 is a conceptual diagram schematically illustrating a non-volatile memory device according to an embodiment of the present invention.
FIG. 9 is a side cross-sectional view illustrating an isotope battery according to a further embodiment of the present invention.
FIG. 10a is a side cross-sectional view illustrating an isotope battery according to a further embodiment of the present invention.
FIG. 10b is a partially enlarged perspective view illustrating the first region, radiation source, and insulating layer of isotope battery of FIG. 10a.
FIG. 11 is a side cross-sectional view illustrating an isotope battery according to a further embodiment of the present invention.

### [Detailed Description of Exemplary Embodiments]

Hereinafter, preferred embodiments of the present invention will be described in detail with reference to the accompanying drawings. However, the embodiments of the present invention may be modified in many other ways, and it should not be construed that the present invention is limited by the embodiments described below. Like designations generally refer to like elements. Furthermore, the various elements and areas in the drawings are schematically depicted. Accordingly, the present invention is not limited by the relative sizes or spacing depicted in the accompanying drawings.

Terms such as "first," "second," and the like may be used to describe various components, but the components are not limited by such terms. These terms are used only for the purpose of distinguishing one component from another. For example, a first component may be named a second component, and vice versa, a second component may be named a first component, without departing from the scope of the concept of the present invention.

The terms used in this application are used to describe certain embodiments only and is not intended to limit the present invention. Expressions in the singular include the plural unless the context clearly indicates otherwise. In this application, expressions such as "includes" or "has" are intended to designate the presence of the features, numbers, steps, operations, components, parts, or combinations thereof described, and are not to be understood as precluding the possibility of the presence or addition of one or more other features, numbers, operations, components, parts, or combinations thereof.

Unless otherwise defined, all terms used herein, including technical and scientific terms, shall have the same meaning as commonly understood by one of ordinary skill in the art to which the concept of the present invention belongs. It is further understood that such terms, as commonly used and as defined in dictionaries, are to be construed to have a meaning consistent with their meaning in the context of the art to which they relate and are not to be construed in an unduly formal sense unless expressly defined herein.

When some embodiments can be implemented differently, certain processes may be performed in a sequence other than that described. For example, two successively described processes may be performed substantially simultaneously, or in the opposite order from the order described.

In the accompanying drawings, variations in the illustrated shapes may be expected, for example, due to manufacturing techniques and/or tolerances. Accordingly, embodiments of the present invention should not be construed as limited to the specific shape of the areas shown herein, and should include, for example, variations in shape resulting from manufacturing processes. All terms "and/or" used herein include each and every combination of one or more of the components mentioned. Further, the term "substrate" as used herein may refer to the substrate itself, or to a laminated structure including the substrate and any predetermined layers or films formed on its surface. Further, as used herein, the term "surface of the substrate" may refer to the exposed surface of the substrate itself, or to the outer surface of a predetermined layer or film formed on the substrate.

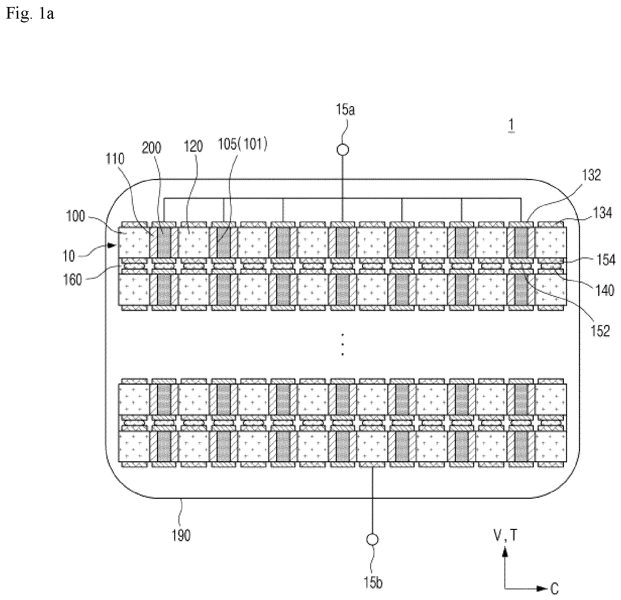

FIG. 1a is a side cross-sectional view exemplarily illustrating an isotope battery 1.

Referring to FIG. 1a, the isotope battery 1 may include a plurality of isotope cell sheets 10 that are stacked on top of each other in a vertical direction V, or a substrate thickness direction.

Each of the plurality of isotope cell sheets 10 may include a semiconductor substrate 100 and at least one radiation source 200.

The semiconductor substrate 100 may comprise a first surface and a second surface positioned opposite to the first surface in a substrate thickness direction T. The first surface and the second surface may be the top and bottom major surfaces of the semiconductor substrate 100, respectively. The semiconductor substrate 100 may include a first region 110 disposed on a side of the radiation source 200 and a second region 120 disposed on a side of the first region 110.

Generally, as schematically shown in FIG. 1a, the first region 110 and the second region 120 may be arranged adjacent to one another. The first region 110 and the second region 120 may be repeatedly an/or alternately disposed along the direction the first and the second surface of the semiconductor substrate 100 extends, or in other words, in a substrate transverse direction C which is perpendicular to the substrate thickness direction T. For example, the first region 110 and the second region 120 may form an interface extending in the substrate thickness direction T. At the interface, the first region 110 and the second region 120 may form a p-n-junction.

The radiation source 200 may be disposed in the semiconductor substrate 100. For example, the radiation source 200 may extend all through the semiconductor substrate, e.g., from the first - or top major - surface to the second - or bottom major - surface in the substrate thickness direction T. To this end, the radiation source 200 may be disposed in a cavity 105 formed in the first surface of the semiconductor substrate 100. The cavity 105 may extend from the first surface toward the second surface of the semiconductor substrate 100, and optionally, all the way till the second surface of the semiconductor substrate 100, as exemplarily shown in FIG. 1a.

The substrate 100 may include, for example, III-V group semiconductor materials. The III-V group semiconductor materials may include at least one of InAlP, InGaP, InAlGaP, ZnSe, AlAs, AlAsP, or yttria-stabilized zirconia (YSZ).

The substrate 100 may include a diamond substrate, a SiC substrate, a GaN substrate, a Bi₂O₃/GeO₂ substrate, a Sm₂O₃/Bi₂O₃/GeO₂ substrate, a Sm₂O₃/Bi₂O₃/B₂O₃ substrate, Sm₂O₃/Bi₂O₃/GeO₂/B₂O₃ substrate, sapphire substrate, or a combination thereof, and may be undoped substrates.

Otherwise, the substrate 100 may include a diamond substrate, a SiC substrate, a GaN substrate, a Bi₂O₃/GeO₂ substrate, a Sm₂O₃Bi₂O₃/GeO₂ substrate, a Sm₂O₃/Bi₂O₃/B₂O₃ substrate, Sm₂O₃/Bi₂O₃/GeO₂/B₂O₃ substrate, sapphire substrate, or a combination thereof, and may be doped with a dopant.

In other embodiments, the substrate 100 may have the chemical formula AMO₃ (wherein A is one or more selected from the group consisting of La, Ba, Sr, and K, and M is one or more selected from the group consisting of Al, In, Ga, Ti, Sn, Hf, Ta, and Zr).

Specifically, the substrate 100 may include one or more selected from the group consisting of BaSnO₃, BaHfO₃, BaZrO₃, BaHf₁₋ₓTiₓO₃ (where 0<x<1), Ba₁₋ₓLaₓSnO₃ (where 0<x<1), Bi₄Ge₃O₁₂, Al₂O₃, Y₂O₃, La₂O₃, Ga₂O₃, Bi₂O₃, ZrO₂, HfO₂, Ta₂O₅, TiO₂ LaInO₃, LaGaO₃, SrZrO₃, SrHfO₃, SrTaO₂, LaIn₁₋ₓGaₓO₃ (where 0 < x < 1), LaGaO₃, SrTiO₃, KTaO₃, HfSiO₄, Ta₃Ti₂Oₓ, and LaAlO₃ (where 0<x<1).

The substrate 100 may include a semiconductor substrate. Otherwise, the substrate 100 may include an insulating substrate.

The first region 110 may include a metal oxide having a bandgap energy of 2.7 eV or more. The metal oxide may have the chemical formula AMO₃ (where A is one or more selected from the group consisting of La, Ba, Sr, and K, and M is one or more selected from the group consisting of Al, In, Ga, Ti, Sn, Hf, Ta, and Zr).

Specifically, the metal oxides may include one or more selected from the group consisting of BaSnO₃, BaHfO₃, BaZrO₃, BaHf₁₋ₓTiₓO₃ (where 0<x<1), Ba₁₋ₓLaₓSnO₃ (where 0<x<1), Bi₄Ge₃O₁₂, Al₂O₃, Y₂O₃, La₂O₃, Ga₂O₃, Bi₂O₃, ZrO₂, HfO₂, Ta₂O₅, TiO₂, LaInO₃, LaGaO₃, SrZrO₃, SrHfO₃, SrTaO₂, LaIn₁₋ₓGaₓO₃ (where 0 < x < 1), LaGaO₃, SrTiO₃, KTaO₃, HfSiO₄, Ta₃Ti₂Oₓ, and LaAlO₃ (where 0<x<1).

The metal oxides are not only stable in high-temperature and high-humidity environments but also have high carrier mobility, enabling them to efficiently absorb radiation emitted from the radiation source 200 and/or photons emitted from the subsequently described photon generating layer 210, thereby providing high energy conversion efficiency. Additionally, there are no inelastic collisions in carrier mobility, resulting in no energy loss and achieving favorable heat dissipation. For example, the metal oxides can have carrier mobility of 45 cm²/(V·s) or higher, 80 cm²/(V·s) or higher, 120 cm²/(V·s) or higher, and even 300 cm²/(V·s) or higher.

These metal oxides are materials that can be doped in any conductivity type and have the advantage of being able to provide high current or high voltage depending on the direction of the applied bias.

The first region 110 and the second region 120 can generate electron-hole pairs by radiation emitted by the radiation source 200. For example, the first region 110 and the second region 120 may be arranged in an inorganic layer, an organic layer, a dye sensitized layer, or a combination thereof, and may generate power by forming electron-hole pairs by radiation.

The first region 110 may be doped with a dopant of a first conductive type. The second region 120 may be doped with a dopant of a second conductive type. For example, the first conductive dopant may be an n-type dopant and the second conductive dopant may be a p-type dopant. Alternatively, the dopant of the first conductive type may be a p-type dopant and the dopant of the second conductive type may be an n-type dopant. Generally, the first and second regions 110, 120 may be of different conductive types. One of ordinary skill in the art will understand that depending on the conductivity type of the dopants doped in each region, one of the first region 110 and the second region 120 may act as a cathode and the other may act as an anode. That is, if the dopant of the first conductive type is n-type dopant and the dopant of the second conductive type is p-type dopant, then the first region 110 may act as an anode and the second region 120 may act as a cathode. Conversely, if the dopant of the first conductive type is a p-type dopant and the dopant of the second conductive type is an n-type dopant, the first region 110 can act as a cathode and the second region 120 can act as an anode.

The n-type doped region may be, for example, silicon or diamond doped with nitrogen (N), phosphorus (P), arsenic (As), or antimony, which are nitrogen group elements of the periodic table, or it may be a compound semiconductor doped with nitrogen (N), phosphorus (P), arsenic (As), or antimony, which are nitrogen group elements of the periodic table. As used herein, a compound semiconductor refers to a semiconductor composed of two or more elements, such as silicon carbide, silicon oxide, aluminum phosphide (AlP), aluminum arsenide (AlAs), gallium arsenide (GaAs), or gallium nitride (GaN).

The p-type doped region may be, for example, silicon or diamond doped with any of the boron group elements of the periodic table, such as boron (B), aluminum (Al), gallium (Ga), or indium (In), or may be a compound semiconductor doped with any of the boron group elements of the periodic table, such as boron (B), aluminum (Al), gallium (Ga), or indium (In).

Optionally, the first region 110 and the second region 120 may include an organic material used in organic layers that receive light to generate power, such as in solar cell applications. For example, the first region 110 and the second region 120 may include a thiophene-like compound. Meanwhile, the first region 110 and the second region 120 may be inorganic-organic hybrids, including any suitable mix of inorganic and organic materials described above.

A depletion region may be formed near the interface where the first region 110 and the second region 120 contact each other.

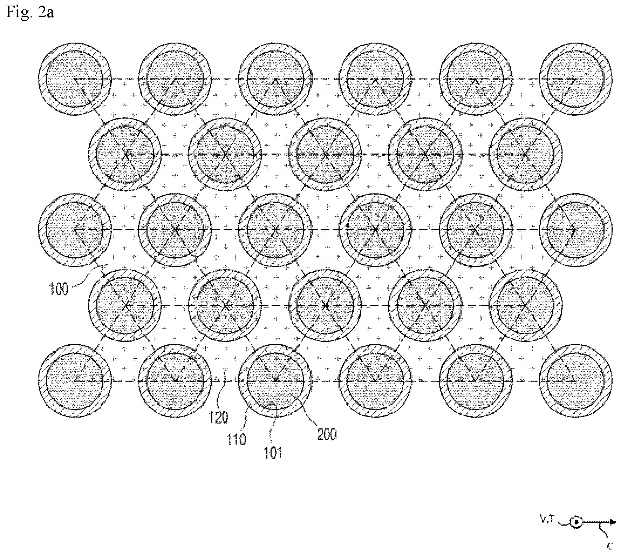

As described above, the radiation source 200 may be provided within a cavity 105 formed in the first surface of the semiconductor substrate. For example, the radiation source 200 may partially or completely fill the cavity 105. Preferably, the radiation source 200 is in contact with the circumference of the cavity 105. As exemplarily shown in FIG. 1a, the cavity 105 may be realized as a through-hole running through the entire thickness of the semiconductor substrate 100. FIGS. 2a to 2c are plan views illustrating the configuration in which a plurality of the radiation sources 200 is disposed in the through-hole 101, according to the present invention.

As exemplarily shown in FIG. 2a, the substrate 100 may be provided with a plurality of through-holes 101 extending from the top major surface to the bottom major surface of the substrate 100, and the radiation source 200 may be disposed within the through-holes 101. The through-holes 101, as shown in FIG. 2a, may have a circular cross-section. Alternatively, the through-holes 101 may have a cross-section of a regular polygon, e.g., a triangle, a rectangle, a pentagon, a hexagon, etc. Generally, a plurality of cavities 105 may be provided within the substrate, irrespective of whether the cavity 105 extends completely through the substrate 100.

The through-holes 101 may be formed by any method known to those skilled in the art. For example, the through-holes 101 may be formed by methods such as anisotropic etching, isotropic etching, or laser irradiation. The through-holes 101 may be formed by irradiating the substrate 100 with laser light. Otherwise, the through-holes 101 may be formed by reactive ion etching (RIE).

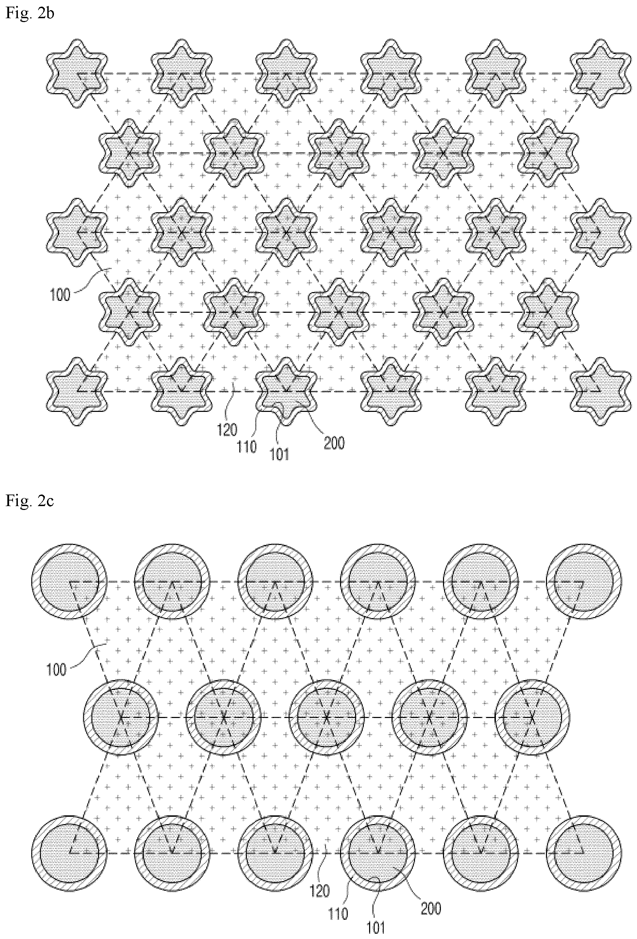

Optionally, the through-holes 101 may be arranged with a predetermined regularity or pattern. For example, the through-holes 101 may be disposed so that their respective centers are located at the vertices of a series of imaginary equilateral triangles, as exemplarily shown in FIG. 2 (e.g., a two-dimensional (2D) hexagonal lattice). In some implementations, other arrangements of the through-holes 101 can be used such as square lattice, rectangular lattice, non-lattice arrangements, and the like.

By disposing the through-holes 101 so that their centers are located at the vertices of the imaginary equilateral triangles, the number of radiation sources 200 that can be accommodated per unit area can be maximized. Therefore, energy density of the isotope battery can be further increased.

Generally, the first region 110 may be disposed to surround the radiation source 200 at least partially. For example, the first region 110 may surround an outer circumference of the radiation source 200, as exemplarily shown in FIG. 2a. In a more general example, the first region 110 may be disposed adjacent to the cavity 105 and extend along at least a section of the circumference of the cavity 105. The second region 120 may be disposed to surround the first region 110 at least partially. For example, the first region 110 may be disposed in the form of frames surrounding the respective cavities 105, and the remaining part of the semiconductor substrate 100 may be formed with the second region 120. Alternatively, the second region 120 may be disposed in the form of frames surrounding the respective first region 110.

Referring to FIG. 2b, the side walls of the through-holes 101 may have irregularities. That is, the circumference of the through-holes 101 may have concave portions and convex portions. The interface between the radiation source 200 and the first region 110 may have irregularities. Preferably, the interface between the first region 110 and the second region 120 may have irregularities.

The first region 110 may have a substantially constant lateral thickness as shown in FIG. 2b. Accordingly, the interface between the first region 110 and the second region 120 may have a shape corresponding to the interface between the radiation source 200 and the first region 110.

Since the side walls of the through-holes 101 have irregularities, the contact area between the radiation source 200 and the first region 110 can increase, thus improving the efficiency of the radiation source 200. Additionally, the interface between the first region 110 and the second region 120 has a corrugated shape, the contact area between the first region 110 and the second region 120 increases, thereby improving the efficiency of the isotope battery 1.

Referring to FIG. 2c, the centers of the through-holes 101 may be arranged such that they are positioned at the vertices of a series of virtual isosceles triangles. That is, the centers of the through-holes 101 need not necessarily be positioned exactly at the vertices of the equilateral triangles, as is with the examples shown in Figs. 2a and 2b. Alternatively, the triangles, at whose vertices the centers of the through-holes 101 are positioned, may have different shapes from each other. In this case, the through-holes 101 may be arranged somewhat irregularly.

As discussed above, the cavity 105 may be realized as a through-hole 101. However, the invention is not limited to this configuration. For example, the cavity 105 may also be a recess with a closed bottom. Otherwise, the cavity 105 may be in the form of a longitudinal opening, e.g., a slit or a trench, having a longitudinal extension in at least one direction on the first surface. The longitudinal opening may as well extend through the entire thickness of the substrate or not.

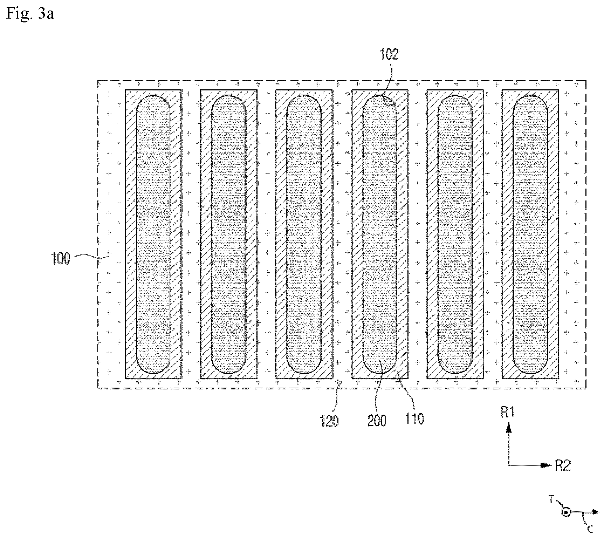

FIG. 3a is a plan view exemplarily illustrating how the radiation source 200 may be disposed within the cavity 105 formed as a longitudinal opening, or a slit 102.

Referring to FIG. 3a, the substrate 100 may include a plurality of slits 102 extending in parallel in one direction. Further, a radiation source 200 may be disposed within the slits 102. As shown in FIG. 3a, the cavity 105 may have a longitudinal extension in a first direction R1 which is greater than a width of the cavity 105 in a second direction R2, wherein the first direction is perpendicular to the substrate thickness direction T, and the second direction R2 is perpendicular to both the substrate thickness direction T and the first direction R1.

Preferably, a side of the radiation source 200 may contact a side of the slits 102. Generally, the radiation source 200 may be in contact with a circumference of the cavity 105.

Optionally, the first region 110 may be disposed to face a longitudinally extended side of the radiation source 200. Preferably, the first region 110 may face both sides of the longitudinal extension of the radiation source 200. For example, the first region 110 may extend along two longitudinal sides of the cavity 105 extending in the first direction R1. More preferably, as exemplarily shown in FIG. 3a, the first region 110 may completely surround the longitudinally extending cavity 105. Generally, the first region 110 may be disposed to surround the radiation source 200 completely or at least partially.

The second region 120 may be disposed to face a longitudinally extended side of the first region 110. For example, the second region 120 may extend along the part of the first region 110 which extends along the longitudinal side of the cavity 105. More preferably, as exemplarily shown in FIG. 3a, the second region 120 may completely surround the first region. Generally, the second region 120 may be disposed to surround the first region 110 at least partially.

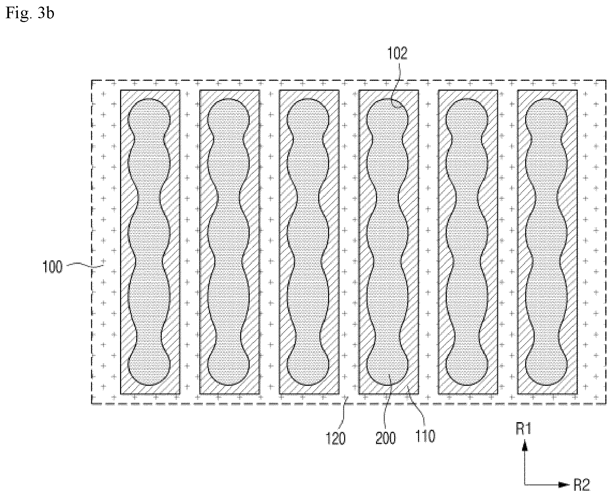

Referring to FIG. 3b, longitudinal extensions, or side walls, of the slits 102 may have irregularities. That is, the longitudinal extensions of the slits 102 may have concave and convex portions. Thus, the interface between the radiation source 200 and the first region 110 may have irregularities.

Since the longitudinal extensions, or side walls of the slits 102 have irregularities, a contact area between the radiation sources 200 and the first region 110 can be increased, thereby improving efficiency of the radiation source 200.

In FIGS. 1a to 3b, the entire portion that is not the first region 110 of the substrate 100 is shown as a second region 120, but the present invention is not limited to this. In FIGS. 1a to 3b, regions of different conductive types or dopant concentrations may be present in the interior of the second region 120, or regions that are not doped with a particular conductive type may be present.

Referring again to FIG. 1a, the plurality of isotope cell sheets 10 stacked on top of one another may have an identical configuration, obtained from identical semiconductor dies.

As further exemplarily shown in FIG. 1a, each of the isotope cell sheets 10 may include a first upper electrode 132, which may be provided at an upper part of the first region 110, e.g., on the top major surface of the substrate 100. Additionally or alternatively, the cell sheet 10 may include a first lower electrode 152, which may be provided at a lower part of the first region 110, e.g., on the bottom major surface of the substrate 100. Generally, the first upper electrode 132 may be in electrical contact with the first region 110 at the first surface, and the first lower electrode 152 may be in contact with the first region 110 at the second surface.

Further, each of the isotope cell sheets 10 may include a second upper electrode 134, which may be provided at an upper part of the second region 120, e.g. on the top major surface of the substrate 100, and a second lower electrode 154, which may be provided at a lower part of the second region 120, e.g., at the bottom major surface of the substrate 100.

Each of the first upper electrode 132, the first lower electrode 152, the second upper electrode 134, and the second lower electrode 154 may act substantially as a current collector. Each of the first upper electrode 132, the first lower electrode 152, the second upper electrode 134, and the second lower electrode 154 is not particularly limited in type, size, and shape as long as it is electrically conductive without causing physical and chemical changes to the isotope cell sheets 10. For example, each of the first upper electrode 132, the first lower electrode 152, the second upper electrode 134, and the second lower electrode 154 may be cylindrical, tetrahedral, hexahedral, torus, or pad-shaped. Furthermore, each of the first upper electrode 132, the first lower electrode 152, the second upper electrode 134, and the second lower electrode 154 may have a hollow center portion.

Further optionally, at the first surface, the second upper electrode 134 may, for example, be a continuous layer comprising openings arranged corresponding to the first regions 110, and the first upper electrodes 132 may be positioned in said openings. Similar, at the second surface, the second lower electrode 154 may, for example, be a continuous layer comprising openings arranged corresponding to the first regions 110, and the first lower electrodes 152 may be positioned in said openings.

Each of the first upper electrode 132, the first lower electrode 152, the second upper electrode 134, and the second lower electrode 154 may include, for example, a metallic material such as gold (Au), silver (Ag), platinum (Pt), stainless steel, copper (Cu), aluminum (Al), nickel (Ni), or titanium (Ti), or may include transparent oxides such as fluorine (F)-doped tin oxide (FTO) or indium tin oxide (ITO, In₂O₃), or may include carbon-based compounds such as carbon-nanotubes, graphene, or graphene oxide.

The radiation source 200 may include a radioactive isotope that emits beta rays. For example, the radiation source 200 may include one or more selected from a group consisting of tritium (³H), calcium-45 (⁴⁵Ca), nickel-63 (⁶³Ni), copper-67 (⁶⁷Cu), strontium-90 (⁹⁰Sr), promethium-147 (¹⁴⁷Pm), osmium-194 (¹⁹⁴Os), thulium-171 (¹⁷¹Tm thallium-204 (²⁰⁴Tl), tantalum-182 (¹⁸²Ta), cadmium-115 (¹¹⁵Cd), cadmium-113 (¹¹³Cd), germanium-75 (⁷⁵Ge), cerium-141 (¹⁴¹Ce), cerium-144 (¹⁴⁴Ce), and tungsten-185 (¹⁸⁵W). However, the present invention is not limited to these.

Alternatively, the radiation source 200 may include a radioactive isotope that emits alpha rays. For example, the radiation source 200 may include one or more selected from a group consisting of americium-241 (²⁴¹Am), americium-243 (²⁴³Am), polonium-209 (²⁰⁹Po), polonium-210 (²¹⁰Po), plutonium-238 (²³⁸Pu), plutonium-239 (²³⁹Pu), curium-242 (²⁴²Cm), curium-244 (²⁴⁴Cm), curium-249 (²⁴⁹Cm), promethium-147 (¹⁴⁷Pm), uranium-238 (²³⁸U), thorium-232 (²³²Th), radium-226 (²²⁶Ra), bismuth-210 (²¹⁰Bi), neptunium-237 (²³⁷Np), europium-152 (¹⁵²Eu), francium-223 (²²³Fr), astatine-210 (²¹⁰At), protactinium-231 (²³¹Pa), einsteinium-253 (²⁵³Es), californium-252 (²⁵²⁰Cf), and berkelium-249 (²⁴⁹Bk). However, the present invention is not limited to these.

The radiation source 200 may be formed by any method known to those skilled in the art. For example, the radiation source 200 may be formed by various methods such as plating, vapor deposition, atomic layer deposition (ALD), etc.

Otherwise, the radiation source 200 may be formed by plating. When the radiation source 200 is formed by plating, a seed layer may be formed, followed by electroplating to form the radiation source 200. Optionally, the radiation source 200 may also be formed by electroless plating.

The first lower electrode 152 of a respective cell sheet 10 may be electrically connected to the first upper electrode 132 of a further cell sheet 10 positioned directly underneath. Optionally, the first lower electrode 152 of the isotope cell sheet 10 stacked on top and the first upper electrode 132 of the isotope cell sheet 10 disposed thereunder may be connected by a connector 140, for example, a solder ball.

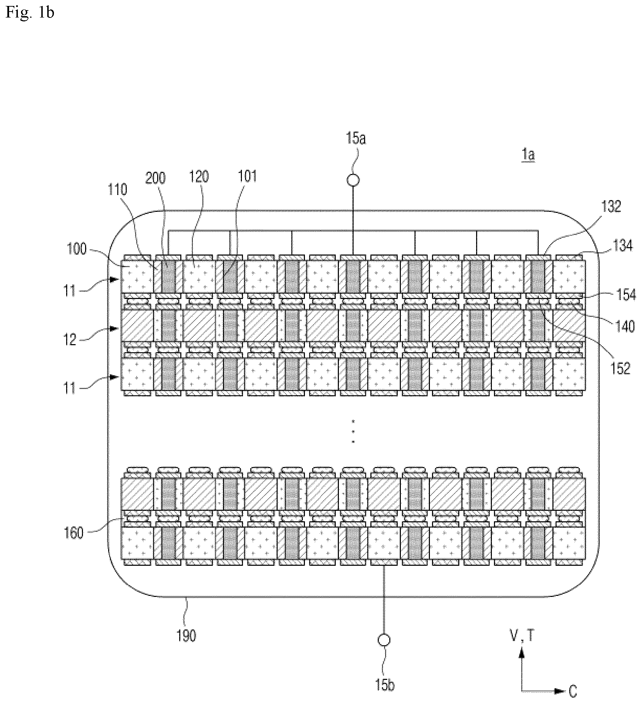

The connector 140 may include a conductive material. Here, the conductive material may include one or more selected from the group consisting of, for example, tin (Sn), indium (In), bismuth (Bi), antimony (Sb), copper (Cu), silver (Ag), zinc (Zn), and lead (Pb). The number, spacing, arrangement, and shape of the connectors 140 may be varied by design, without limitation to those shown. Referring to FIG. 1, the connectors 140 may have the shape of solder balls or solder bumps.

The space between two vertically neighboring isotope cell sheets 10 may be filled by an insulator 160. The insulator 160 is not limited as long as it is any material having electrically insulating properties, and may include, for example, one or more selected from the group consisting of silicate (e.g., TEOS), silicon nitride (SiN), hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, barium titanium oxide, strontium titanium oxide, yttrium oxide, and aluminum oxide, and may include one or more selected from the group consisting of strontium titanium oxide, yttrium oxide, and aluminum oxide. Alternatively, the insulating layer 160 may be a passivation layer, or there may be a passivation layer in addition to the insulating layer 160.

The isotope battery 1 shown in FIG. 1a can be obtained by manufacturing individual isotope cell sheets 10 and then stacking them on top of one another. By manufacturing individual isotope battery sheets 10 and then stacking, defective isotope battery sheets 10 can be selectively excluded during the course of stacking, thereby improving the yield of the isotope battery 1 and reducing manufacturing costs.

The plurality of isotope cell sheets 10 may be housed within a housing 190. The plurality of isotope cell sheets 10 may also be electrically connected to an external load by conductors drawn out to the outside through the housing 190.

In some embodiments, the housing 190 may further include an electromagnetic interference (EMI) shield (not shown) capable of shielding electromagnetic waves. The EMI shield may be formed on at least a portion of an inner surface and/or an outer surface of the housing 190. The EMI shield may include, for example, a metal such as copper, aluminum, a conductive polymer such as polyaniline, or a magnetic material such as iron oxide. The EMI shield may also be provided in the form of a sheet, mesh, applied layer, spray coating, nonwoven fabric, tape, or fabric layer. By faithfully providing the housing 190 with an EMI shield, the electromagnetic compatibility (EMC) of the isotope battery 1 can be ensured. In addition, the EMI shield can prevent or otherwise restrict beta rays or other radiation (e.g., alpha rays or gamma rays) from exiting the housing 190.

The first upper electrodes 132 of the isotope cell sheet 10 disposed at the topmost part of FIG. 1a may be electrically connected to each other and electrically connected to a first outer electrode 15a of first polarity. Further, the second lower electrodes 154 of the isotope cell sheet 10 disposed at the lowest part of FIG. 1a may be electrically connected to a second outer electrode 15b of second polarity. The first outer electrode 15a and second outer electrode 15b may be exposed to the outside of the housing 190 for connection to an external load.

Optionally, the second lower electrodes 154 of the isotope cell sheet 10 disposed at the lowest part in FIG. 1a may be electrically connected to each other by surrounding the first lower electrodes 152. For example, as already described above, the second lower electrodes 154 may be realized as a continuous layer. Alternatively, the second lower electrodes 154 may be electrically connected to each other by separate conductive lines (not shown) and to the second outer electrode 15b exposed outside the housing 190. The external load to which the first outer electrode 15a and the second outer electrode 15b are connected can include an electronic device, an electro-chemical battery, an energy storage device, or other devices. In operation, the isotope battery 1 in FIG. 1a has many p-n junctions in parallel, so that the output electrical current flowing through the first outer electrode 15a and the second outer electrode 15b is a sum of the individual currents of the individual p-n junctions in each of the plurality of beta battery sheets 10.

FIG. 1b is a side cross-sectional view illustrating another isotope battery 1a.

Referring to FIG. 1b, the isotope battery 1a may comprise a first isotope cell sheet 11 and a second isotope cell sheet 12 alternately and repeatedly stacked.

The first isotope cell sheet 11 is substantially the same as the isotope cell sheet 10 described with reference to FIG. 1a, and therefore will not be described in detail again.

The second isotope cell sheet 12 differs from the first isotope cell sheet 11 in that the conductive types of the dopants is reversed. That is, if the first region 110 of the first isotope cell sheet 11 may be p-type doped, and the first region 110 of the second isotope cell sheet 12 may be n-type doped. Conversely, if the first region 110 of the first isotope cell sheet 11 is n-type doped, the first region 110 of the second isotope cell sheet 12 may be p-type doped.

Similarly, if the second region 120 of the first isotope cell sheet 11 is p-type doped, the second region 120 of the second isotope cell sheet 12 may be n-type doped. Conversely, if the second region 120 of the first isotope cell sheet 11 is n-type doped, the second region 120 of the second isotope cell sheet 12 may be p-type doped.

In the isotope battery 1a of FIG. 1b, the first and second cell sheets 11, 12 are connected electrically in series, whereas in the battery of FIG. 1a, the cell sheets 10 are connected electrically in parallel. Therefore, the isotope battery 1a shown in FIG. 1b can obtain higher voltage electrical energy because a number of individual radiation sources 200 and individual p-n junctions are respectively connected in series. The first outer contact 15a and the second outer contact 15b can have a higher operating voltage than in the beta battery 1 of FIG. 1a because in FIG. 1b, the p-n junctions are connected in series so that the overall output voltage is the sum of the individual p-n junction voltages.

Optionally, the current collected by the p-n junctions in the beta battery 1a may follow a meandering path.

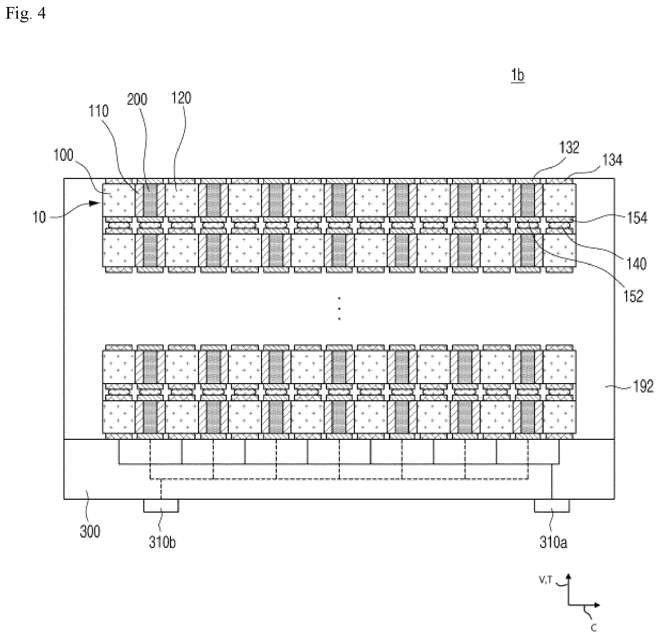

FIG. 4 is a side cross-sectional view illustrating a further isotope battery 1b.

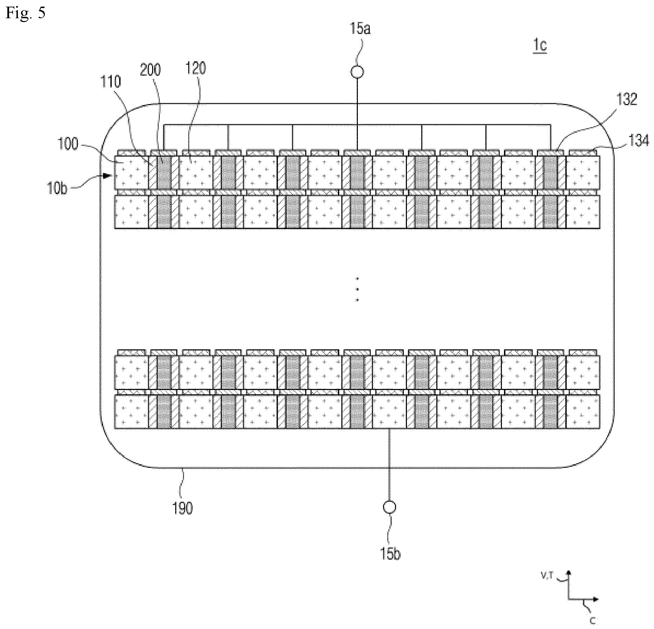

The isotope battery 1b shown in FIG. 4 is substantially the same as the isotope battery 1 described with reference to FIG. 1a, but differs in that the plurality of isotope cell sheets 10 are enclosed by or embedded in a molding member 192 and the plurality of isotope cell sheets 10 are mounted on a controller chip 300. Accordingly, the following discussion will focus on these differences and omit discussion of the commonalities. It should be understood that any of the isotope batteries 1, 1a of FIGS. 1 to 3 as well as any one of the isotope batteries of FIGS. 5 to 7, which are described below, may also be mounted on a controller chip 300 and/or embedded in a molding member 192.

Referring to FIG. 4, the plurality of isotope cell sheets 10 are mounted on a controller chip 300. For example, the controller chip 300 may include a power management integrated circuit (PMIC) that outputs electrical energy generated by the plurality of stacked isotope cell sheets 10 to the an outside world external load (e.g., an energy storage device, a capacitor, an electrochemical battery, a lithium-ion battery, etc.) according to predetermined rules.

The plurality of isotope cell sheets 10 may be molded with a molding member 192. The molding member 192 may include, for example, an epoxy molding compound (EMC).

The first upper electrode 132 and the second upper electrode 134 at the topmost part of isotope cell sheet 10 may act as dummy electrodes when the plurality of isotope cell sheets 10 are electrically connected to the controller chip 300 through the first and second lower electrodes 152, 154 provided on the lowermost cell sheet 10, as exemplarily shown in FIG. 4. Optionally, at least one of the first upper electrode 132 and the second upper electrode 134 disposed at the topmost isotope cell sheet 10 may be exposed to the outside through the molding member 192. During the EMC molding process, these electrodes 132, 134 may contact the molding die, so as to be finally exposed from the EMC molding member. Alternatively, the first upper electrode 132 and the second upper electrode 134 disposed at the topmost isotope cell sheet 10 may be completely covered by the molding member 192. Alternatively, the upper surface of the topmost beta battery sheet of the plurality of beta battery sheets 10 lacks both the first upper electrode 132 and the second upper electrode 134 and is instead covered by a passivation layer or by the molding member 192 or by both the passivation layer and the molding member 192.

The electrical energy generated by the plurality of isotope cell sheets 10 may be supplied to an external load via external terminals 310a, 310b provided on the controller chip 300. In FIG. 4, the plurality of isotope cell sheets 10 are shown mounted on the upper part of the controller chip 300, but the present invention is not limited to this.

FIG. 5 is a side cross-sectional view illustrating a further isotope battery 1c.

Referring to FIG. 5, the isotope battery 1c may include a plurality of isotope cell sheets 10b stacked in the vertical direction V, or the substrate thickness direction.

The isotope cell sheet 10b differs from the isotope cell sheet 10 of FIG. 1a in that the lower electrodes 152, 154 and the connector 140 are omitted. Therefore, the following discussion will focus on these differences and omit discussion of the commonalities.

The isotope cell sheet 10b includes a first upper electrode 132 and a second upper electrode 134 on the upper surface. Optionally, the isotope cell sheets 10b of the plurality of stacked isotope cell sheets 10b may all be of an identical configuration, having been obtained from an identical semiconductor die.

The first upper electrode 132 and the second upper electrode 134 of the isotope cell sheet 10b lying underneath may be in direct contact with the bottom surfaces of the first region 110 and the second region 120, respectively, of the isotope cell sheet 10b disposed on top. In other words, on a respective cell sheet 10b, first upper electrodes 132 and second upper electrodes 134 may only be provided on the first - or top major - surface of the semiconductor substrate 100, and the second - or bottom major - surface of a semiconductor substrate 100 of a respective cell sheet 10b may be in electrical contact with the electrodes 132, 134 provided on the first - or top major - surface of the semiconductor substrate 100 of a cell sheet 10b arranged directly thereunder.

The isotope battery 1c may be more compactly configured since the lower electrodes 152, 154 and the connector 140 are omitted, thus increasing the energy density.

Further optionally, first regions 110 of neighboring cell sheets 10b and the second regions 120 of neighboring cell sheets may be disposed in direct contact with each other, thus, omitting any electrodes between neighboring cell sheets within the stack.

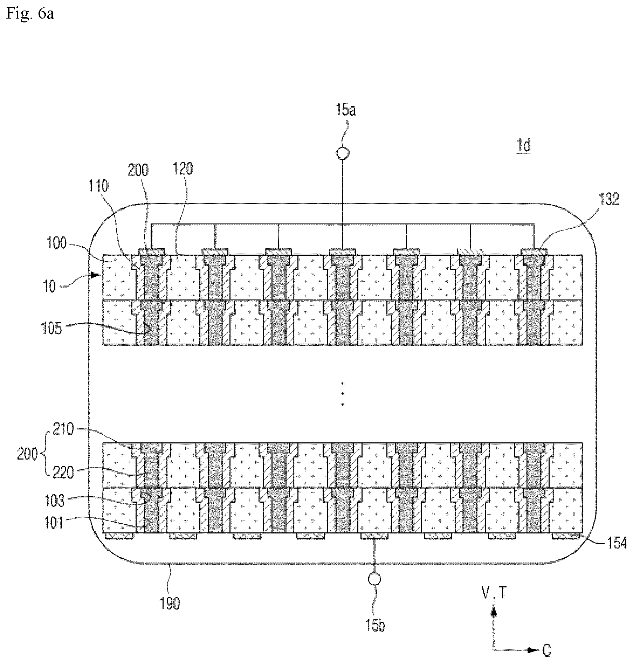

FIG. 6a is a side cross-sectional view illustrating a further isotope battery 1d.

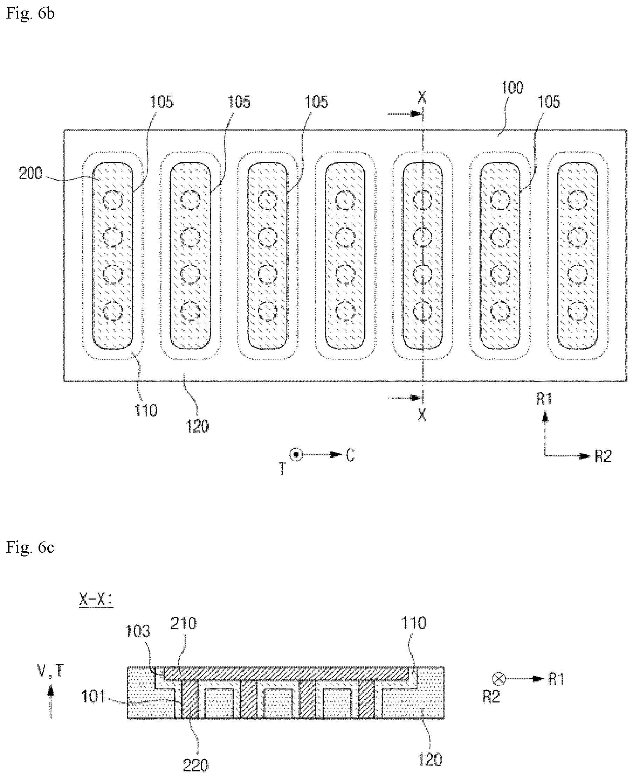

Referring to FIG. 6a, the isotope battery 1d may include a plurality of stacked isotope cell sheets 10c. FIG. 6b is a plan view of a cell sheet of the isotope battery of FIG. 6a. FIG. 6c is a cross-sectional view along line X-X of FIG. 6b.

The cell sheets 10c shown in FIGS. 6a, 6b and 6c differ from those shown in FIG. 1a mainly in the configuration of the cavity 105. As exemplarily shown in FIG. 6a, the cavity 105 has a shape of a stepped recess. The cavity 105 may comprise a trench or recess 103 formed in the first surface of the substrate 100. In addition, one or more through-holes 101 may extend between a bottom of the recess 103 and the second surface of the substrate 100.

That is, the isotope cell sheet 10c may include a trench 103 extending along the upper surface of the substrate 100 and a through-hole 101 extending from a bottom surface of the trench 103 to a lower surface of the substrate 100. As exemplarily shown in FIG. 6b, the recess 103 may extend longitudinally in the first direction R1, and the through-hole 101 may extend vertically from a bottom surface of the trench 103. Optionally, a plurality of through-holes 101 may be arranged along the first direction R1 within a single recess or trench 103, as exemplarily shown in FIGS. 6b and 6c.

Inside the recess 103 and in the plurality of through-holes 101, a radiation source 200 may be provided. The radiation source 200 may include a first portion 210 disposed within the recess 103. Further, the radiation source 200 may include a second portion 220 disposed within the through-hole 101, extending from the bottom of the trench 103 to the second - or bottom major - surface of the substrate 100.

Preferably, the thickness of the recess 103 may be in a range of about 10 % to about 50 % of the thickness of the beta battery sheet 10c. In the meantime, the thickness of the through-hole 101 may be in a range of about 50 % to about 90 % of the thickness of the beta battery sheet 10c.

The width of the first portion 210 in the second direction R2 may be larger than the width of the second portion 220 in the second direction R2. Here, the second direction R2 is perpendicular to the first direction R1. The width in the second direction R2 of the first region 110 corresponding to the first portion 210 may be larger than the width in the second direction R2 of the first region 110 corresponding to the second portion 220.

The first region 110 of the substrate 100 may have a substantially constant thickness between the surfaces of the radiation sources 200.

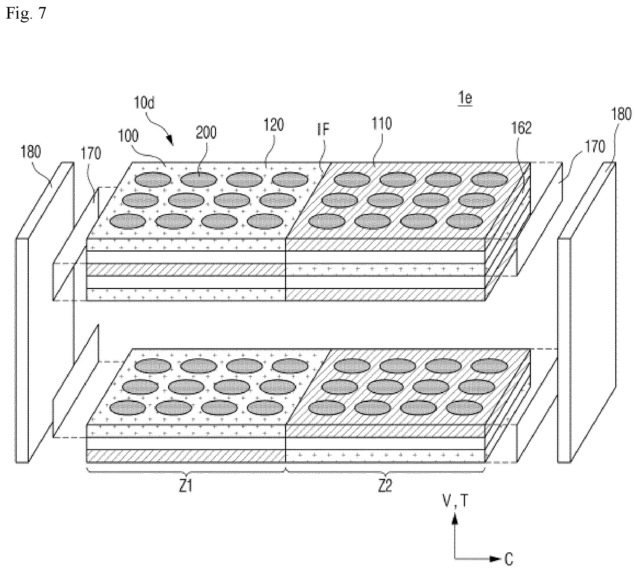

FIG. 7 is a side cross-sectional view illustrating a still further isotope battery 1e.

Referring to FIG. 7, the isotope battery 1e includes a plurality of substrates 100 stacked in a vertical direction V to form a stack. As described above, the substrate may have a first surface - or top major surface - and a second surface - or bottom major surface - positioned opposite to the first surface in a substrate thickness direction T. Further, each substrate 100 comprises a first region 110 of a first conductive type and a second region 120 of a second conductive type. The first and the second region 110, 120 form a p-n-junction at an interface IF therebetween. Further, the first and second regions 110, 120 of a respective substrate 100 may be arranged adjacent to each other in a substrate transverse direction C extending transverse to the substrate thickness direction T.

As schematically shown in FIG. 7, the interfaces IF of the respective substrates 100 stacked on top of one another are aligned in the vertical direction V, so that the interfaces (IF) overlap one another. This effectively divides the stack into a first zone Z1 and a second zone Z2 at opposite sides of the aligned interfaces IF. In other words, the first zone Z1 and the second zone Z2 are neighboring with an interface IF therebetween. Each of the plurality of substrates 100 corresponds to one isotope cell sheet 10d.

Each of the plurality of substrates 100 includes a plurality of radiation sources 200 extending vertically through it. For example, each substrate 100 may comprise a plurality of cavities 105, and one radiation source 200 may be disposed in each cavity 105. The cavities 105 may extend through the respective substrate 100, i.e., from the first surface toward - or optionally till - the second surface. Further optionally, as exemplarily shown in FIG. 7, the cavities 105 may be realized as through-holes with a circular cross-section. However, the invention is not limited to this configuration.

A plurality of radiation sources 200 may be provided in each of a first zone Z1 and a second zone Z2. The radiation sources 200 in the first zone Z1 and the radiation sources 200 in the second zone Z2 may be arranged symmetrically with respect to the interface IF.

In a single substrate 100, the first zone Z1 and the second zone Z2 may have different conductive types. If the first zone Z1 is a first region 110 of a first conductive type across the interface IF, the second zone Z2 is a second region 120 of a second conductive type. Conversely, if the first zone Z1 across the interface IF is the second region 120 of the second conductive type, then the second zone Z2 is the first region 110 of the first conductive type.

In addition, the two vertically neighboring substrates 100 in the first zone Z1 have different conductive types. That is, if the a respective substrate 100 located in the first zone Z1 is the first region 110 of the first conductivity type, the substrate 100 located directly underneath is the second region 120 of the second conductive type. Similarly, if the respective substrate 100 in the first zone Z1 is the second region 120 of the second conductive type, then the substrate 100 located directly underneath is the first region 110 of the first conductive type.

Furthermore, the two vertically neighboring substrates 100 in the second zone Z2 have different conductive types. That is, if the respective substrate 100 in the second zone Z2 is the first region 110 of the first conductivity type, the substrate 100 located directly underneath is the second region 120 of the second conductive type. Similarly, if the respective substrate 100 in the second zone Z2 is the second region 120 of the second conductive type, then the substrate 100 located directly underneath is the first region 110 of the first conductive type.

In the first zone Z1, two vertically neighboring substrates 100 are electrically connected to each other. In addition, two vertically neighboring substrates 100 in the second zone Z2 are electrically connected to each other. Optionally, a pair of vertically neighboring substrates 100 may be electrically connected by a current collector 170. As exemplarily shown in FIG. 7, the current collector 170 may be provided on the sides of the stacked semiconductor substrates 100. That is, the current collector 170 may connect lateral side end faces of neighboring semiconductor substrates 100, wherein the lateral side end face of the respective semiconductor substrate 100 extends between the first and the second surface of the respective semiconductor substrate 100. The current collector 170 connecting the semiconductor substrates 100 in the first zone Z1 may be disposed at the end farthest spaced apart from the second zone Z2. Furthermore, the current collector 170 connecting the semiconductor substrates 100 of the second zone Z2 may be disposed at the end farthest spaced apart from the first zone Z1.

It is also possible that the current collector 170 may be alternately provided on both sides of the plurality of stacked isotope cell sheets 10d. In other words, if the N^{th} and (N+1)^{th} isotope cell sheets 10d of the plurality of isotope cell sheets 10d are connected to the current collector 170 on one side, the (N+1)^{th} and (N+2)^{th} isotope cell sheets 10d may be connected to the current collector 170 on the other side. The outer side of the current collector 170 may be provided with an insulating bulkhead 180 to protect the current collector 170. For example, the insulating bulkhead 180 may extend in the vertical direction V to span the entire height of the plurality of stacked isotope cell sheets 10d.

Optionally, the radiation sources 200 of each of the plurality of stacked semiconductor substrates 100 may be vertically aligned. That is, the radiation sources 200 of the substrate 100 located at the upper part may be vertically aligned with the radiation sources 200 of the semiconductor substrate 100 located at the lower part. For example, the cavities 105 in which the radiation sources 200 are received may be aligned in the vertical direction V, e.g., their center axes may be arranged coaxially. Although not shown in FIG. 7, the plurality of cavities 105 may be disposed in the semiconductor substrate 100 such that their respective centers are located at the vertices of an imaginary equilateral triangle.

Further optionally, the radiation sources 200 may extend vertically through the plurality of stacked semiconductor substrates 100.

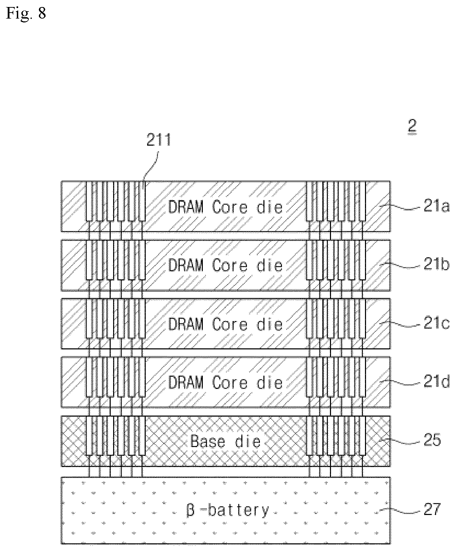

FIG. 8 is a conceptual diagram schematically illustrating a non-volatile memory device 2.

Referring to FIG. 8, the non-volatile memory device 2 may include a plurality of semiconductor memory devices 21a, 21b, 21c, 21d and a memory control unit 25 configured to control the operation thereof.

For example, the plurality of semiconductor memory devices 21a, 21b, 21c, 21d may be vertically stacked, and each of them may have a through electrode 211. The through electrodes 211 may include a through silicon via (TSV). Each of the plurality of semiconductor memory devices 21a, 21b, 21c, 21d may be electrically connected to the memory control device 25 via the through electrode 211. Each of the plurality of semiconductor memory devices 21a, 21b, 21c, 21d may be a dynamic random access memory (DRAM) chip.

The non-volatile memory device 2 may further include an isotope battery 27 configured to power the memory control device 25. The isotope battery 27 may be any of the isotope batteries 1, 1a, 1b, 1c, 1d, or 1e described above.

DRAM devices have significantly higher read and write speeds compared to flash memory, but have the disadvantage that the stored information is lost when the power is cut off. The non-volatile memory device 2 of FIG. 8 uses a DRAM device as a memory element, so it can be used as a portable data storage device because it has a high read speed and write speed, and because it is continuously powered by the isotope battery 27, the information stored in the DRAM device can be maintained without being lost.

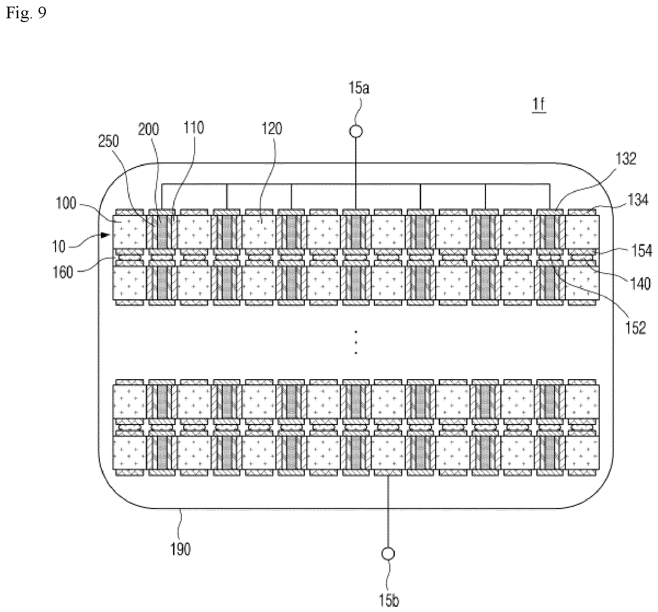

FIG. 9 is a cross-sectional view exemplarily showing another isotope battery 1f. The isotope battery If in FIG. 9 differs from the isotope battery 1 shown in FIG. 1a in that it further includes a photon generating layer 210. The following description will focus on these differences.

Referring to FIG. 9, the photon generating layer 210 may, for example, be disposed around the radiation source 200. For example, the photon generating layer 210 may surround the outer circumference of the radiation source 200. As exemplarily shown in Fig. 9, the photon generating layer 210 may be positioned, with respect to the substrate transverse direction (i.e., in an extension direction of the top and bottom major surfaces of the substrate), between the radiation source 200 and the inner circumference of the cavity 105 in which the radiation source is received. The photon generating layer 210 can protect the semiconductor layers in which p-n-junction is formed from being damaged by radiation emitted from the radiation source 200.

The photon generating layer 210 may be any material layer capable of emitting photons when irradiated with radiation particles, such as alpha particles, emitted from the radiation source 200. The radiation source 200 may be a material that emits alpha particles or beta particles. Examples of such materials have been described with reference to FIG. 1a. Therefore, repetition is refrained from here.

For example, the photon generating layer 210 may employ materials such as Ba₂Ca(BO₃)₂, BaHfO₃, BaI₂:Ce, BeO, BaF₂, BaMgF₄, Cs₂LiLuCi₆:Ce, K₂YF₅, KCaF₃, YI₃:Ce, but is not limited to these. Various examples that can be used for the photon generating layer 210 are disclosed in the following document: https://scintillator.lbl.gov/inorganic-scintillator-library/.

The photon generating layer 210 can emit photons in response to alpha or beta particles incident from the radiation source 200. The photons generated in the photon generating layer 210 can be incident on the junction region between the first region 110 and the second region 120, so that electrical energy can be generated by the photons.

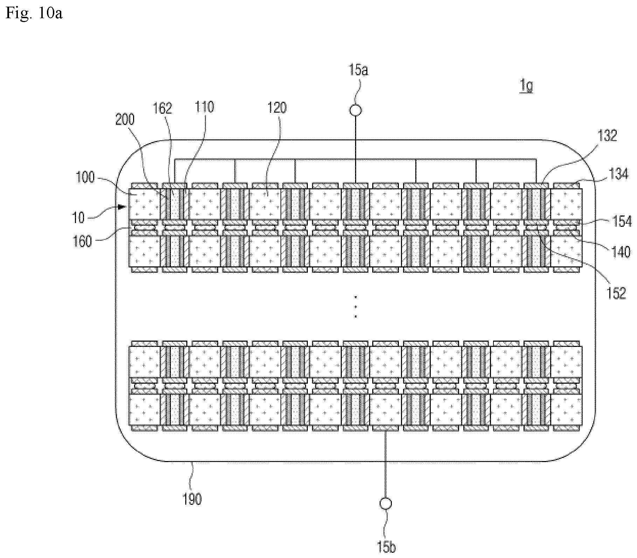

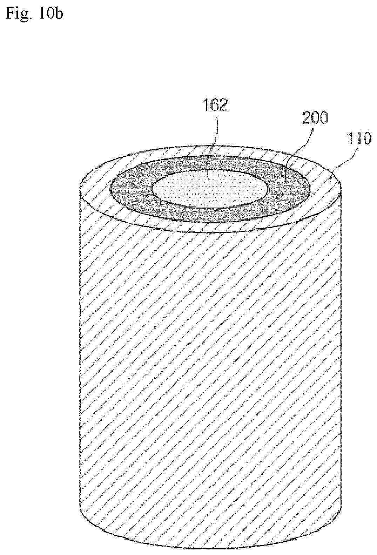

FIG. 10a is a side view of another isotope battery 1g, and FIG. 10b is a partial enlarged perspective view of the first region 110, radiation source 200, and insulating layer 162 of the isotope battery 1g shown in FIG. 10a. The isotope battery 1g shown in FIGS. 10a and 10b differs from the isotope battery 1 shown in FIG. 1a in that the radiation source 200 has an annular shape, and the following description will focus on this difference.

Referring to FIGS. 10a and 10b, the radiation source 200 may have a longitudinal shape with a central opening. Generally, the radiation source may extend along a longitudinal axis, and the central opening may be formed along the longitudinal axis. For example, a central axis of the central opening may be parallel to or coaxial with the longitudinal axis. For example, as shown in FIGS. 10a and 10b, the radiation source may have a hollow tube shape with a central opening. More generally, the radiation source 200 may have the shape of a cylinder, preferably a right cylinder, with a central opening. In this context, the cylinder is not limited to a circular cylinder. Rather, the bases of the cylinder may be of any shape, e.g., a circle, a polygon, an ellipse, etc.

Preferably, the central opening of the radiation source 200 may be filled with an insulating material 162. Alternatively, the central opening may be filled with the same material of which the substrate 100 is formed or a semiconductor material derived therefrom. The radiation source 200 may have a substantially uniform thickness, e.g., a substantially uniform wall thickness, measured between an outer circumferential surface of the radiation source 200 and an inner circumferential surface defining the cross-section of the central opening. As schematically shown in FIG. 10a, the radiation source 200 may extend along the interface with the first region 110.

If the interior of the radiation source 200 is provided with a central opening, which may be filled as described above, the amount of material required to form the radiation source 200 can be reduced. Since the price of the radiation source material is high, forming the radiation source 200 in this hollow shape allows the isotope battery 1g to be manufactured at a lower cost, without compromising the size of the contact area between the radiation source 200 and the first region 110.

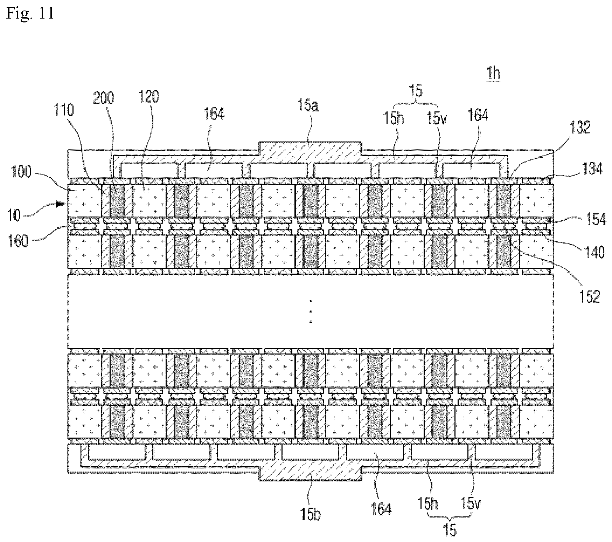

FIG. 11 is a cross-sectional view of another example of an isotope battery 1h. The isotope battery 1h shown in FIG. 11 differs from the isotope battery 1 shown in FIG. 1a in the configuration of the external electrodes 15a, 15b, and the following description will focus on these differences.

Referring to FIG. 11, the isotope battery 1h includes a first external electrode 15a and a second external electrode 15b for supplying electrical energy to an external load.

The first external electrode 15a includes conductive members 15 connected to the first upper electrodes 132 of the isotope cell sheet 10. The conductive members 15 may, as exemplarily shown in FIG. 11, extend within an insulator layer 164 disposed on the uppermost cell sheet 10. The conductive members 15 are electrically connected only to the first upper electrodes 132.

The conductive members 15 may include a first conductive member 15h and second conductive members 15v, wherein the first and second conductive members 15h, 15v extend in different directions. The second conductive members 15v may be electrically connected to the first conductive members 15h and to the first upper electrodes 132. The first conductive members 15h may be physically and/or electrically connected to the first external electrode 15a. The first conductive member 15h may extend in a horizontal direction, e.g., parallel to the substrate transverse direction C, and the second conductive members 15v may extend transverse to the respective first conductive member 15h to which they are connected. For example, the second conductive members 15v may extend in a vertical direction, e.g., in the substrate thickness direction T. However, the present invention is not limited thereto.

Optionally, the second upper electrodes 134 of the isotope cell sheets 10 closest to the first external electrode 15a may be omitted.

The second external electrode 15b may also be electrically connected to the isotope cell sheets 10 in a manner similar to the first external electrode 15a. The second external electrode 15b includes conductive members 15 connected to the second lower electrodes 154 of the isotope cell sheet 10. The conductive members 15 may, as exemplarily shown in FIG. 11, extend within an insulator layer 164 disposed on the lowermost cell sheet 10. The conductive members 15 are electrically connected only to the second electrodes 154.

The conductive members 15 may include a first conductive member 15h and second conductive members 15v, wherein the first and second conductive members 15h, 15v extend in different directions. The second conductive members 15v may be electrically connected to the first conductive members 15h and to the second lower electrodes 154. The first conductive members 15h may be physically and/or electrically connected to the second external electrode 15b. The first conductive member 15h may extend in a horizontal direction, e.g., parallel to the substrate transverse direction C, and the second conductive members 15v may extend transverse to the respective first conductive member 15h to which they are connected. For example, the second conductive members 15v may extend in a vertical direction, e.g., in the substrate thickness direction T. However, the present invention is not limited thereto.

A person skilled in the art will be able to consider other wiring connections between the second external electrode 15b and the isotope cell sheets 10 by referring to the wiring connection between the first external electrode 15a and the isotope battery sheets 10 described above. Although embodiments of the invention have been described in detail above, one of ordinary skill in the art to which the present invention belongs will be able to make many modifications to the present invention without departing from the scope of the present invention as defined in the appended claims.

## Claims

1. An isotope battery (1, 1a, 1b, 1c, 1d, 1f, 1g, 1h) comprising:
a plurality of isotope cell sheets (10, 10b, 10c, 11, 12), each of the cell sheets (10, 10b, 10c, 11, 12) including:
a) a semiconductor substrate (100) having a top major surface and a bottom major surface positioned opposite to the top major surface in a substrate thickness direction, wherein the semiconductor substrate (100) includes:
a-1) a first region (110) and a second region (120) of different conductive types, forming a p-n-junction, wherein the first region (110) and the second region (120) are arranged adjacent to each other along an extension direction of the top and bottom major surfaces; and
a-2) a cavity (105) extending from the top major surface in the substrate thickness direction, at a position spaced apart from the p-n-junction; and
b) a radiation source (200) arranged in the cavity (105),
wherein the plurality of cell sheets (10, 10b, 10c, 11, 12) are stacked on top of each other in a direction parallel to the substrate thickness direction; and
a first external electrode of a first polarity and a second external electrode of a second polarity respectively connected to the plurality of isotope cell sheets (10, 10b, 10c, 11, 12)to provide an electrical connection to an external load.

2. The isotope battery (1, 1a, 1b, 1c, 1d, 1f, 1g, 1h) of claim 1, wherein the semiconductor substrate (100) includes a plurality of cavities, and a respective radiation source (200) is provided inside each of the plurality of cavities.

3. The isotope battery (1, 1a, 1b, 1c, 1d, 1f, 1g, 1h) of claim 1 or 2, wherein the cavity (105) extends till the bottom major surface.

4. The isotope battery (1, 1a, 1b, 1c, 1f, 1g, 1h) of claim 3, wherein the cavity (105) is a through-hole (101) having a cross-sectional shape of a circle or a regular polygon or substantially a regular polygon.

5. The isotope battery (1, 1a, 1b, 1c, 1f, 1g, 1h) of any one of claims 2 to 4, insofar as dependent upon claim 2, wherein the plurality of cavities (105) are disposed in the semiconductor substrate (100) such that their respective centers are located at vertices of an imaginary triangle, preferably an imaginary equilateral or isosceles triangle.

6. The isotope battery (1, 1b, 1c, 1f, 1g, 1h) of any one of claims 1 to 3, wherein the cavity (105) has, on the top major surface, a longitudinal extension substantially greater than a width thereof.

7. The isotope battery (1, 1a, 1b, 1c, 1f, 1g, 1h) of any one of the preceding claims, wherein the first region (110) surrounds the radiation source (200) at least partially, and the second region (120) surrounds the first region (110) at least partially.

8. The isotope battery (1, 1a, 1b, 1c, 1f, 1g, 1h) of claim 7, insofar as dependent upon claim 6, wherein the first region (110) extends along the longitudinal extension of the cavity (105), facing a longitudinal side of the radiation source (200), and the second region (120) extends along the longitudinal extension of the cavity (105), facing a longitudinal side of the first region (110).

9. The isotope battery (1d) of any one of claims 1 to 3, wherein the cavity (105) includes a stepped recess having a first recess (103) at the top major surface of the semiconductor substrate (100), and a through hole (101) running from a bottom of the first recess (103) toward the bottom major surface of the semiconductor substrate (100), and
the radiation source (200) comprises a first portion (210) disposed in the first recess (103), and a second portion (220) in the through hole (101).

10. The isotope battery (1, 1a, 1b, 1c, 1d, 1f, 1g, 1h) of any one of the preceding claims, wherein the plurality of isotope cell sheets (100) are identically configured.

11. The isotope battery (1, 1a, 1b, 1c, 1d, 1f, 1g, 1h) of any one of the preceding claims, wherein center lines running through the radiation sources (200) of the stacked cell sheets (10, 10b, 10c, 11, 12) are aligned to form a straight line.

12. The isotope battery (1, 1a, 1b, 1c, 1d, 1f, 1g, 1h) of any one of the preceding claims, wherein at least a part of the p-n-junction of a respective cell sheet (10, 10b, 10c, 11, 12) is aligned with at least a part of the p-n-junction of another cell sheet (10, 10b, 10c, 11, 12) disposed directly on top or underneath, so that the p-n junctions substantially overlap each other.

13. The isotope battery (1, 1a, 1b, 1c, 1d, 1f, 1g, 1h) of any one of the preceding claims, wherein the plurality of isotope cell sheets (10, 10b, 10c, 11, 12) are electrically connected to each other by connectors (140).

14. The isotope battery (1, 1a, 1b, 1c, 1d, 1f, 1g, 1h) of any one of the preceding claims, wherein the first regions of cell sheets (10, 10b, 10c, 11, 12) disposed directly on top and underneath are electrically connected to each other, and the second regions (120) of cell sheets (10, 10b, 10c, 11, 12) disposed directly on top and underneath are electrically connected to each other.

15. An isotope battery (1e), comprising:
a plurality of semiconductor substrates (100), each semiconductor substrate (110) including:
a) a top major surface and a bottom major surface positioned opposite to the top major surface in a substrate thickness direction;
b) a first region (110) of a first conductive type and a second region (120) of a second conductive type, forming a p-n-junction at an interface (IF) therebetween, wherein the first region (110) and the second region (120) are arranged adjacent to each other along an extension direction of the top and bottom major surfaces; and
c) a plurality of cavities (105) in each of the first and second regions (110, 120),
wherein the semiconductor substrates (100) are stacked on top of each other in a direction parallel to the substrate thickness direction, forming a stack,
wherein the interfaces (IF) of the stacked semiconductor substrates (100) disposed directly on top and underneath are aligned, so that the interfaces (IF) overlap each other, forming a first zone (Z1) and a second zone (Z2) at opposite sides of the aligned interfaces (IF), and
wherein respectively in the first zone (Z1) and the second zone (Z2), the first and the second region (110, 120) are alternately stacked; and
a plurality of radiation sources (200) disposed in the plurality of cavities (105).

16. The isotope battery (1e) of claim 15, wherein the cavities (105) are arranged such that the radiation sources (200) in the first zone (Z1) and the radiation sources (200) in the second zone (Z2) are symmetrically arranged with respect to the interface (IF).

17. The isotope battery of any one of the preceding claims, further comprising a controller chip provided on one side of the plurality of isotope cell sheets (10, 10b, 10c, 11, 12) of any one of claims 1 to 14, or the plurality of semiconductor substrates (100) of any one of claims 15 to 16, wherein the controller chip is configured to control output of electrical energy generated.

18. The isotope battery (1, 1a, 1b, 1c, 1d, 1f, 1g, 1h) of any one of the preceding claims, wherein the plurality of cell sheets (10, 10b, 10c, 11, 12) of any one of claims 1 to 14, or the plurality of semiconductor substrates (100) of any one of claims 15 to 16 are embedded in a molding resin.

19. The isotope battery (1, 1a, 1b, 1c, 1d, 1f, 1g, 1h) of claim 18, wherein at least one dummy electrode is exposed through the molding resin.

20. The isotope battery (1g) of any one of the preceding claims, wherein the radiation source (200) extends longitudinally and has a central opening extending in the longitudinal direction.

21. The isotope battery (1g) of claim 20, wherein the radiation source is cylindrically shaped.

22. The isotope battery (1g) of claim 20 or 21, wherein the central opening is filled, preferably with an insulating material (162) or a semiconductor material.

23. The isotope battery (1f) of any one of the preceding claims, further comprising:
a photon generating layer (210) disposed to at least partially surround the radiation source (200), so that radiation emitted by the radiation source (200) is incident on the photon generating layer (210),
wherein the photon generating layer (210) is configured to emit photons in response to being irradiated by the radiation source (210) towards the p-n-junction of a respective isotope cell sheet (10, 10b, 10c, 11, 12) of any one of claims 1 to 14 or a respective semiconductor substrate (100) of any one of claims 15 to 16.

24. The isotope battery (1f) of claim 23, wherein the photon generating layer (210) is disposed between the p-n-junction and the radiation source (200).

25. A non-volatile memory device (2), comprising:
at least one semiconductor memory device (21a, 21b, 21c, 21d);
a memory control device (25) configured to control operation of the at least one semiconductor memory device (21a, 21b, 21c, 21d); and
an isotope battery (1, 1a, 1b, 1c, 1d) of any one of the preceding claims configured to power the memory control device (25).

26. The non-volatile memory device (2) of claim 25, wherein the semiconductor memory device (21a, 21b, 21c, 21d) is a DRAM chip.
